# EUROPÄISCHE PATENTANMELDUNG

(11) **EP 2 326 006 A1**
(43) Veröffentlichungstag der Anmeldung: **25.05.2011**
(21) Anmeldenummer: 09176272.4
(22) Anmeldetag: 18.11.2009
(51) Int. Cl.: H03K 17/10, H03K 17/18, G05B 9/02, B66B 5/00

(54) **Schalter einer elektrischen Anlage**

(71) Anmelder: Inventio AG, 6052 Hergiswil NW (CH)
(72) Erfinder: Sonnenmoser, Astrid, 6030, Ebikon (CH); Michel, David, 8800, Thalwil (CH); Hess, Martin, 6340, Baar (CH); Heinz, Kurt, 8107, Buchs (CH)

(57) **Zusammenfassung**

Es wird ein Verfahren zum Schliessen eines Schalters (S) einer elektrischen Anlage und ein Schalter (S) einer elektrischen Anlage, welcher einen Eingang (E), einen Ausgang (A), mindestens zwei in Serie geschaltete Halbleiterschalter (S1, S2), die zwischen dem Eingang (E) und dem Ausgang (A) angeordnet sind, und mindestens eine Steuereinheit (P, P1, P2), welche mit den mindestens zwei Halbleiterschalter (S1, S2) verbunden ist, beschrieben. Erfindungsgemäss wird von der mindestens einen Steuereinheit (P, P1, P2) abwechselnd jeweils einer der mindestens zwei Halbleiterschalter (S1, S2) geschlossen. Von der mindestens einen Steuereinheit (P, P1, P2) wird jeweils überprüft, ob ein Signal an dem Ausgang (A) anliegt und nur bei Ausbleiben des jeweiligen Signals werden die mindestens zwei Halbleiterschalter (S1, S2) von der mindestens einen Steuereinheit (P, P1, P2) geschlossen.

## Beschreibung

Die Erfindung betrifft einen Schalter einer elektrischen Anlage und ein Verfahren zum Schliessen des Schalters.

Bei Schaltern in sicherheitssensiblen Umgebungen werden hohe Anforderungen bezüglich ihrer Ausfallsicherheit gestellt, damit Personenschäden verhindert werden können. Sicherheitssensible Umgebungen existieren überall dort, wo durch einen Ausfall eines Schalters inakzeptable Risiken für die Gesundheit von Menschen entstehen können. Die Anforderungen für sichere Schalter sind in verschiedenen Sicherheitsnormen, wie etwa in der Europäischen Norm IEC 61508, spezifiziert. Die Europäische Norm IEC 61508 enthält die Mindestanforderungen, damit die Sicherheit in Systemen und elektrischen Anlagen erhöht werden kann. Dazu definiert diese Norm vier so genannte Sicherheitsintegritätsstufen SIL1 bis SIL4, welche als Mass für die Betriebssicherheit einer Anlage bzw. eines Systems gelten. Die Sicherheitsintegritätsstufe SIL4 ist dabei die höchste Betriebssicherheitsstufe.

In elektrischen Anlagen, wie etwa, Beförderungsanlagen (Aufzugsanlagen, Fahrtreppen, Förderbänder etc.), Motorensteuerungen, Schaltschränken, Getriebesteuerungen, elektrische Geräte, Industrieanlagen etc., werden die verschiedensten Schalter verwendet. Oftmals werden an diese Schalter besondere Sicherheitsanforderungen gestellt. Die Schalter können bei einer Aufzugsanlage beispielsweise beim Motor bzw. beim Antrieb, bei der Bremseinheit, beim Sicherheitskreis, bei den Türen etc. eingesetzt werden. Beim Sicherheitskreis werden mehrere Sicherheitselemente, wie u. a. Sicherheitsschalter bzw. -kontakte, in einer Serienschaltung angeordnet. Die Schalter bzw. Kontakte überwachen zum Beispiel, ob eine Schachttüre oder die Kabinentüre geöffnet ist. Die Aufzugskabine kann nur bewegt werden, wenn der Sicherheitskreis und damit auch alle in ihm integrierten Sicherheitsschalter bzw. - kontakte geschlossen sind. Einige der Sicherheitselemente werden beispielsweise von den Türen betätigt. Andere Sicherheitselemente, wie zum Beispiel ein Überfahrschalter, werden durch die Aufzugskabine betätigt oder ausgelöst. Der Sicherheitskreis steht mit dem Antrieb oder der Bremseinheit einer Aufzugsanlage in Verbindung, um den Fahrbetrieb zu unterbrechen, falls der Sicherheitskreis geöffnet wird. Auch beim Antrieb und der Bremseinheit können hohe Anforderungen betreffend die Betriebssicherheit und der damit verwendeten Schalter gestellt werden, damit zum Beispiel die Stromzufuhr in einer Gefahrensituation oder einem abnormalen Betriebszustand unterbrochen werden kann oder bei einer Detektion einer Fehlfunktion vom Antrieb oder der Bremseinheit eine von diesen Komponenten ausgehende Gefahr unterbunden werden kann.

Die in Beförderungsanlagen verwendeten Schalter bestehen meist aus elektromechanischen Bauteilen und weisen daher bauartbedingt einige Nachteile, wie etwa dem hohen Verschleiss bzw. die grosse Abnützung oder die Anfälligkeit in Bezug auf Staub und Schmutz, auf. Aber auch das mechanische Geräusch beim Schaltvorgang wird zunehmend als störend empfunden.

Eine Aufgabe der Erfindung ist es, einen verbesserten, sicheren und effizienten Schalter für eine Beförderungsanlage vorzuschlagen.

Die Erfindung wird anhand der unabhängigen Patentansprüche beschrieben. Weiterführungen sind in den abhängigen Ansprüchen angegeben.

Ein Aspekt der Erfindung besteht darin, dass ein Schalter einer elektrischen Anlage und ein Verfahren zum Schliessen des Schalters beschrieben werden. Der Schalter weist einen Eingang, einen Ausgang und mindestens zwei Halbleiterschalter auf, die in Serie zwischen dem Eingang und dem Ausgang geschalten sind. Mit den Halbleiterschaltern ist eine Steuereinheit verbunden, wobei jedem Halbleiterschalter auch eine eigene Steuereinheit zugeordnet sein kann. Zwischen der mindestens einen Steuereinheit und einem Halbleiterschalter kann eine Ansteuereinheit angeordnet sein. Die Verbindung zwischen Steuereinheit und Halbleiterschalter kann galvanisch mittels optischer, magnetischer, kapazitiver etc. Trennelemente getrennt sein. Zum Beispiel kann die Trennung in der Ansteuereinheit geschehen. So können für die mindestens zwei Halbleiterschalter unterschiedliche Ansteuereinheiten mit unterschiedlichen Trennelementen verwendet werden. Der Schalter kann somit mehrkanalig ausgestaltet sein. Unter dem Begriff "mehrkanalig" versteht man allgemein in der Sicherheitstechnik, dass zwei oder mehrere voneinander unabhängige Einheiten verwendet werden. Die Ansteuereinheit besteht aus einem oder mehreren elektronischen Elementen, welche in geeigneter Weise miteinander verbunden werden, damit die Steuereinheit und der Halbleiterschalter miteinander kommunizieren bzw. Signale austauschen können. So könnte es zum Beispiel sein, dass die Steuereinheit und die Halbleiterschalter unterschiedliche Spannungen, Ströme etc. benötigen und die Ansteuereinheit diese ausgleicht bzw. anpasst, sodass die Steuereinheit zum Beispiel den Halbleiterschalter schliessen kann.

Zusätzlich kann die Ansteuereinheit derart ausgestaltet sein, dass sie nur auf ganz bestimmte Stimulationen, zum Beispiel eine definierte Frequenz, eine Spannungsänderung, eine Stromänderung etc., der Steuereinheit reagiert und den Halbleiterschalter schaltet. Diese Ansteuerung weist eine gewisse Komplexität auf, welche nur durch eine intakte Steuereinheit gewährleistet sein kann. Eine defekte bzw. eingeschränkt funktionstüchtige Steuereinheit kann somit nicht ungewollt den Ausgang schliessen.

Beispielsweise könnte dem ersten Halbleiterschalter eine erste Ansteuereinheit mit einem ersten Trennelement, zum Beispiel einem optischen Trennelement, und dem zweiten Halbleiterschalter eine zweite Ansteuereinheit mit einem zweiten Trennelement, zum Beispiel einem magnetischen Trennelement, zugeordnet sein. Als Halbleiterschalter kann erfindungsgemäss jeglicher beliebiger Halbleiterschalter, wie zum Beispiel ein MOSFET, ein IGBT, ein Bipolartransistor, ein Thyristor etc. verwendet werden. Bei zum Beispiel einem Bipolartransistor kann die Ansteuereinheit an der Basis des Bipolartransistors angeschlossen sein, bei einem MOSFET zum Beispiel am Gate.

Zum Schliessen des Schalters wird von der mindestens einen Steuereinheit abwechselnd jeweils einer der mindestens zwei Halbleiterschalter geschlossen. Die mindestens eine Steuereinheit schliesst also den ersten Halbleiterschalter und der mindestens eine weitere Halbleiterschalter bleibt geöffnet. Von der mindestens einen Steuereinheit wird danach überprüft, ob ein Signal am Ausgang des Schalters anliegt. Ein derartiges Signal kann beliebig sein. Zum Beispiel kann das Signal eine Spannung, ein Strom, ein analoges Signal, ein digitales Signal etc. sein. Liegt am Schalter ein Signal an, wird der geschlossene erste Halbleiterschalter wieder geöffnet und der Schalter wird für weitere Schliess-Vorgänge blockiert, da zum Beispiel bei einem der mindestens zwei Halbleiterschaltern ein Kurzschluss vorliegen könnte. Liegt dagegen kein Signal an, wird der mindestens eine weitere Halbleiterschalter geschlossen, wobei der erste Halbleiterschalter geöffnet wird bzw. geöffnet bleibt. Es wird also vorerst immer nur einer der mindestens zwei Halbleiterschalter geschlossen. Wiederum wird von der mindestens einen Steuereinheit überprüft, ob am Ausgang des Schalters ein Signal anliegt. Sollte dabei ein Signal anliegen wird der mindestens eine weitere Halbleiterschalter geöffnet und der Aufzugsschalter wird für weitere Schliess-Vorgänge blockiert. Wurde dagegen von der mindestens einen Steuereinheit festgestellt, dass kein Signal am Schalter anliegt, wird der erste Halbleiterschalter geschlossen, so dass die mindestens zwei Halbleiterschalter geschlossen sind. Damit wird der Schalter insgesamt geschlossen und somit der Stromkreis bzw. Datenbus, sofern der Stromkreis bzw. Datenbus keine weiteren Schalter aufweist.

Ein Vorteil der Erfindung besteht darin, dass der erfindungsgemässe Schalter aufgrund des erfindungsgemässen mehrfachen Überprüfungsverfahrens besonders sicher ist. Erfindungsgemäss kann der Schalter beliebig eingesetzt werden. Er kann dort verwendet werden, wo ein besonders sicherer Schalter benötigt wird. So kann der Schalter in Beförderungsanlagen, zum Beispiel Aufzugsanlagen, Fahrtreppen und deren Komponenten, in Industrieanlagen, bei Motoren, bei Bremseinheiten, im Anlagenbau, in der Computertechnik, für Strom- und Kommunikationsnetzen in Gebäuden etc. verwendet werden.

Ein weiterer Vorteil besteht darin, dass der erfindungsgemässe Schalter durch die Verwendung von Halbleiterschaltern eine lange Lebensdauer aufweist.

Noch ein weiterer Vorteil besteht darin, dass der erfindungsgemässe Schalter geräuscharm bzw. lautlos öffnet und schliesst.

Noch ein weiterer Vorteil besteht darin, dass durch die mehrkanalige Ausgestaltungsform des Schalters sichergestellt werden kann, dass die Steuereinheiten nicht aufgrund einer Fehlfunktion den Schalter ungewollt schliessen.

Die Erfindung wird anhand eines in den Figuren dargestellten Ausführungsbeispiels näher erläutert. Dabei zeigen
- Fig. 1: einen erfindungsgemässen Schalter mit zwei Steuereinheiten,
- Fig. 2: einen erfindungsgemässen Schalter mit einer Steuereinheit und
- Fig. 3: einen erfindungsgemässen Sicherheitskreis einer Aufzugsanlage.

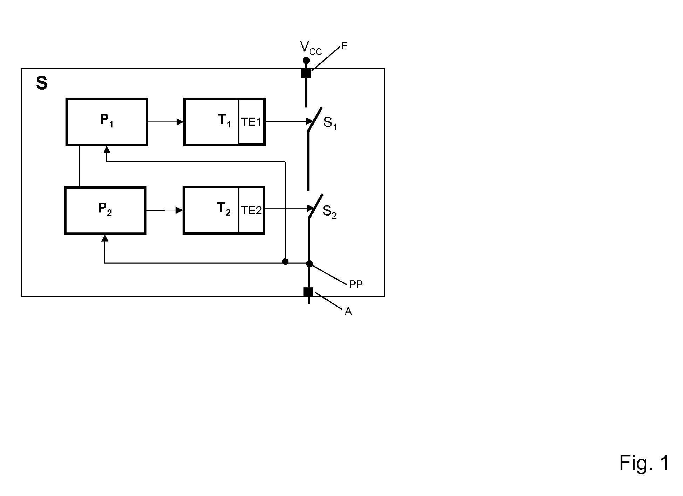

Figur 1 zeigt einen erfindungsgemässen Schalter S mit zwei Steuereinheiten P1, P2. Ein derartiger Schalter S kann zum Beispiel in Aufzügen und in Fahrtreppen eingesetzt werden. Da dieser Schalter S bzw. dieser Aufzugsschalter S hohen Sicherheitskriterien genügt, kann er auch beim so genannten Sicherheitskreis in Aufzügen verwendet werden.

Der Schalter S weist einen Eingang E, einen Ausgang A, zwei in Serie geschaltete Halbleiterschalter S1, S2, die zwischen dem Eingang E und dem Ausgang A angeordnet sind, auf, wobei jeder Halbleiterschalter S1, S2 mit einer Steuereinheit P1, P2 und einer dazwischen angeordneten Ansteuereinheit T1, T2 verbunden ist.

Als Ansteuereinheit T1, T2 wird in diesem Beispiel eine Ansteuereinheit mit einem optischen oder magnetischen Trennelement TE1, TE2 verwendet. Dabei wird das Trennelement TE1, TE2 zur galvanischen Trennung der Verbindung zwischen Steuereinheit P1, P2 und dem Halbleiterschalter S1, S2 verwendet. Selbstverständlich ist für das erfindungsgemässe Verfahren auch eine Ansteuereinheit T1, T2 ohne Trennelement TE1, TE2 vorstellbar. Auch könnte eine Ansteuereinheit T1, T2 mit einem Trennelement TE1, TE2 verwendet werden, welches weder optisch noch magnetisch getrennt ist. Erfindungsgemäss kann somit zum Beispiel eine Ansteuereinheit T1, T2 verwendet werden, die nicht trennend ist, eine kapazitives Trennelement TE1, TE2 oder jegliches anderes Trennelement TE1, TE2 verwendet.

Die Ansteuereinheit T1, T2 kann derart ausgestaltet sein, dass sie (T1, T2) nur bei Vorliegen eines bestimmten Signals bzw. innerhalb eines bestimmten Intervalls, zum Beispiel eine Frequenz, eine Stromänderung, eine Spannungsänderung, eine Spannung, ein Strom etc. in einem definierten Bereich eine Schaltung des Halbleiterschalters S1, S2 zulässt, sodass die Steuereinheit P1, P2 den Halbleiterschalter S1, S2 nur dann ansteuern kann, wenn sie innerhalb des definierten Bereichs ein Signal an den Halbleiterschalter S1, S2 sendet. Liegt die Frequenz, die Stromänderung, die Spannungsänderung etc. ausserhalb des definierten Bereichs, ist ein Schliessen nicht möglich. Damit soll sichergestellt werden, dass der Ausgang nur geschlossen werden kann, wenn die Steuereinheit P1, P2 noch ordnungsgemäss funktioniert. Bei einer Fehlfunktion der Steuereinheit P1, P2 wird dies von der Ansteuereinheit T1, T2 festgestellt und der Schalter S öffnet sich, bzw. kann nicht geschlossen werden.

Vorzugsweise weisen beide Ansteuereinheiten T1, T2 unterschiedliche Trennelemente TE1, TE2 auf, so könnte zum Beispiel die erste Ansteuereinheit T1 ein erstes, zum Beispiel ein optisches, Trennelement TE1 und die zweite Ansteuereinheit T2 ein zweites, zum Beispiel ein magnetisches, Trennelement TE2 oder umgekehrt aufweisen. Jedoch ist ebenso vorstellbar, dass beide Ansteuereinheiten gleiche Trennelemente TE1, TE2 aufweisen. Die Ansteuereinheit T1, T2 kann als eine Art Verstärker- bzw. Anpasseinheit verstanden werden. So kann die Ansteuereinheit T1, T2 eine Schnittstelle von der Steuereinheit P1, P2 zum Halbleiterschalter S1, S2 bilden, damit zum Beispiel der Strom, die Spannung etc. für den Halbleiterschalter S1, S2 angepasst wird.

Jedem Halbleiterschalter S1, S2 ist in diesem Beispiel eine eigene Ansteuereinheit T1, T2 und eine eigene Steuereinheit P1, P2 zugeordnet. Die erste (P1) und die zweite Steuereinheit P2 können miteinander, wie in diesem Beispiel gezeigt, verbunden sein, damit Daten ausgetauscht werden können oder getrennt voneinander betrieben werden können. Der Schalter S wird allgemein zum Schliessen bzw. Öffnen eines Stromkreises, eines Daten-Netzes, eines Daten-Buses etc. verwendet. Als Steuereinheit P1, P2 kann jede beliebige Steuereinheit P1, P2 wie zum Beispiel ein Mikroprozessor, verwendet werden.

Zum Schliessen des Schalters S schliesst die erste Steuereinheit P1 den ersten Halbleiterschalter S1, während die zweite Steuereinheit P2 den zweiten Halbleiterschalter S2 nach wie vor offen hält. In diesem Beispiel überprüfen beide Steuereinheiten P1, P2, ob ein Signal an einem Prüfpunkt PP des Schalters S anliegt. Wenn beispielsweise überprüft werden soll, ob am Prüfpunkt PP eine Spannung anliegt, so kann die Messung von der Steuereinheit P1, P2 beispielsweise gegen die Masse bzw. gegen einen anderen Referenzwert erfolgen. Das Überprüfungsergebnis kann zwischen den Steuereinheiten P1, P2 ausgetauscht werden. Erfindungsgemäss wird überprüft, ob ein Signal am Ausgang A des Schalters S anliegt, jedoch könnte das Anliegen des Signals auch bei einem anderen geeigneten Prüfpunkt PP, zum Beispiel zwischen den Schaltern S1 und S2 überprüft werden. Das zu überprüfende Signal kann beliebig sein. Zum Beispiel kann als Signal eine Spannung, ein Strom, ein analoges Signal, ein digitales Signal, eine Spannungsänderung, eine Stromänderung etc. verwendet werden. Liegt an dem Prüfpunkt PP ein Signal, wie in diesem Beispiel eine Spannung Vcc, an, so wird der erste Halbleiterschalter S1 von der ersten Steuereinheit P1 geöffnet und der Schalter S wird für weitere Schliess-Prozeduren blockiert, da unter Umständen der zweite Halbleiterschalter S2 kurzgeschlossen ist. Liegt dagegen keine Spannung Vcc am Prüfpunkt PP an, so wird der erste Halbleiterschalter S1 von der ersten Steuereinheit P1 wieder geöffnet und der zweite Halbleiterschalter S2 von der zweiten Steuereinheit P2 geschlossen. Wieder wird in diesem Beispiel von den beiden Steuereinheiten P1, P2 überprüft, ob am Prüfpunkt PP eine Spannung Vcc anliegt. Liegt am Prüfpunkt PP eine Spannung Vcc an, so wird der zweite Halbleiterschalter S2 wieder geöffnet und der Schalter S wird für weitere Schliess-Vorgänge blockiert. Wird dagegen keine Spannung Vcc detektiert, schliesst die erste Steuereinheit P1 den ersten Halbleiterschalter S1 und damit wird der Schalter S insgesamt geschlossen. Dieser Schliessvorgang kann auch zu Testzwecken geschehen. Dazu wird zum Beispiel das beschriebene Verfahren in regelmässigen Zeitabständen oder nach mindestens einer vorher bestimmten Regel durchgeführt. Zum Beispiel könnte sich gemäss einer Regel der Schalter S nach der erstmaligen Inbetriebnahme oder nach einem Service selbst testen oder, wenn ein Stromunterbruch stattgefunden hat.

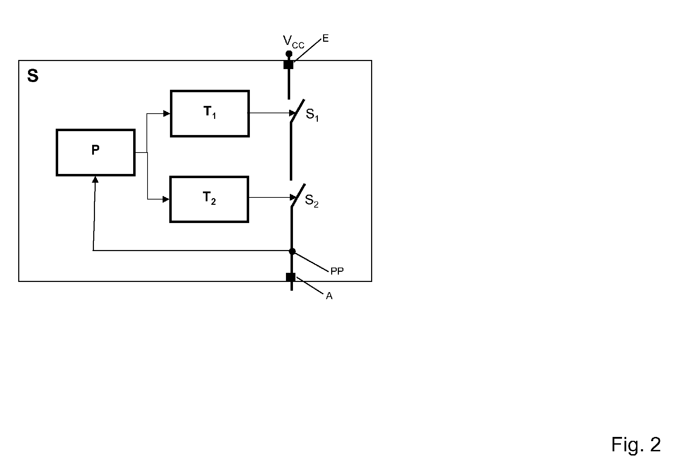

Figur 2 zeigt einen Schalter S einer elektrischen Anlage mit nur einer Steuereinheit P. Auch dieser Schalter S kann beispielsweise sowohl in Beförderungsanlagen, Motorensteuerungen, Getriebestreuungen, Aufzügen als auch in Fahrtreppen eingesetzt werden. Da der Schalter S ebenfalls den hohen Sicherheitskriterien genügt, kann er auch beim so genannten Sicherheitskreis in Aufzügen verwendet werden. Zum Schliessen wird das Verfahren gemäss der Beschreibung in Figur 1 angewandt. In diesem Beispiel weist die Ansteuereinheit T1, T2 keine Trennelemente TE1, TE2 auf. Ein weiterer Unterschied besteht darin, dass die Steuereinheit P sowohl den ersten (S1) als auch den zweiten Halbleiterschalter S2 steuert, öffnet und schliesst und die Überprüfung, ob ein Signal am Schalter S anliegt, nur durch die eine Steuereinheit P erfolgt. Eine weitere erfindungsgemässe Alternative könnte sein, dass nur eine Ansteuereinheit T1 bzw. T2 verwendet wird.

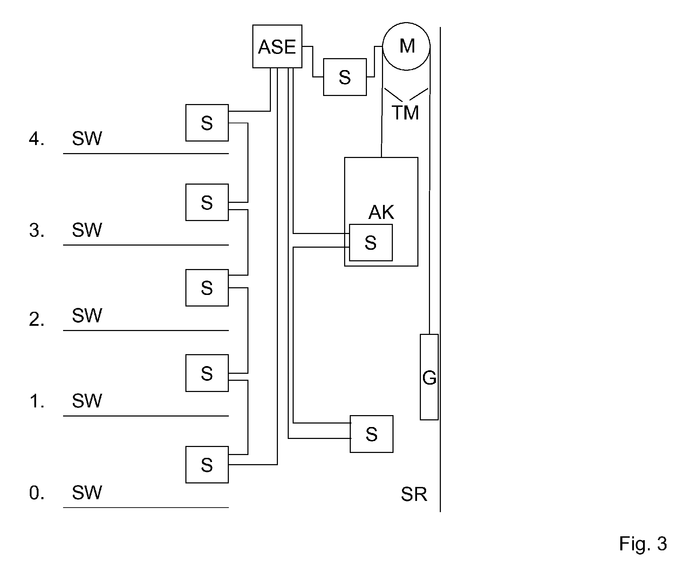

Figur 3 zeigt einen vereinfacht dargestellten Sicherheitskreis in einer Aufzugsanlage mit erfindungsgemässen Schaltern S. In diesem Beispiel wird eine so genannte Treibscheibenaufzugsanlage dargestellt. Selbstverständlich kann der erfindungsgemässe Schalter S auch in anderen Aufzugstypen, wie etwa einem hydraulischen Aufzug, einen gegengewichtslosen Aufzug etc., verwendet werden. Eine Aufzugskabine AK bewegt sich vertikal mittels eines Motors M in einem Aufzugsschacht SR. Dabei ist die Aufzugskabine an einem Tragmittel TM aufgehängt. Gegenläufig zur Aufzugskabine AK bewegt sich ein Gegengewicht G, welches über das Tragmittel TM, zum Beispiel ein Seil, ein Riemen etc., mit der Aufzugskabine AK verbunden ist. Die Steuerung der Aufzugsanlage wird mittels einer Aufzugssteuereinheit ASE realisiert. Die Aufzugssteuereinheit ASE überwacht u. a. auch den bzw. die Sicherheitskreis(e) an dem die erfindungsgemässen Schalter S angeordnet sind. Der Sicherheitskreis SHK kann ein Stromkreis, ein Bussystem etc. sein. In diesem Beispiel sind die Schalter S auf jedem Stockwerk SW angeordnet. Selbstverständlich ist denkbar, dass in dem Sicherheitskreis nur ein Schalter S angeordnet ist und dieser in Abhängigkeit von Meldungen, Signalen etc. der nicht dargestellten Türkontakte den Sicherheitskreis schliesst bzw. öffnet. Auch der Motor M kann einen erfindungsgemässen Schalter S aufweisen, damit zum Beispiel bei einer Gefahrensituation der Motor nicht in Betrieb gehen kann. In der Aufzugskabine AK und im Aufzugsschacht SR können auch erfindungsgemässe Schalter S angeordnet sein. In diesem Beispiel sind mehrere Sicherheitskreise angedeutet. Selbstverständlich könnten die mehreren Sicherheitskreise auch zu einem Sicherheitskreis zusammengefasst sein. Zum Schliessen wird das Verfahren gemäss der Beschreibung in Figur 1 angewandt.

## Patentansprüche

**1.** Verfahren zum Schliessen eines Schalters (S) einer elektrischen Anlage, welcher einen Eingang (E), einen Ausgang (A), mindestens zwei in Serie geschaltete Halbleiterschalter (S1, S2), die zwischen dem Eingang (E) und dem Ausgang (A) angeordnet sind, und mindestens eine Steuereinheit (P, P1, P2), welche mit den mindestens zwei Halbleiterschalter (S1, S2) verbunden ist, aufweist,
wobei von der mindestens einen Steuereinheit (P, P1, P2) abwechselnd jeweils einer der mindestens zwei Halbleiterschalter (S1, S2) geschlossen wird,
wobei von der mindestens einen Steuereinheit (P, P1, P2) jeweils überprüft wird, ob ein Signal an dem Ausgang (A) anliegt und
wobei nur bei Ausbleiben des jeweiligen Signals die mindestens zwei Halbleiterschalter (S1, S2) von der mindestens einen Steuereinheit (P, P1, P2) geschlossen werden.

**2.** Verfahren nach Anspruch 1,
wobei als Signal eine Spannung, ein Strom, ein analoges Signal und/oder ein digitales Signal verwendet werden.

**3.** Verfahren nach Anspruch 1,
wobei zwischen der Steuereinheit (P, P1, P2) und dem Halbleiterschalter (S1, S2) eine Ansteuereinheit (T1, T2) angeordnet wird.

**4.** Verfahren nach Anspruch 3,
wobei bei der Ansteuereinheit (T1, T2) ein Trennelement (TE1, TE2) verwendet wird.

**5.** Verfahren nach Anspruch 4,
wobei bei der ersten Ansteuereinheit (T1) ein erstes Trennelement (TE1) und bei der zweiten Ansteuereinheit (T2) ein zweites Trennelement (TE2) verwendet werden.

**6.** Verfahren nach einem der Ansprüche 3 bis 5,
wobei als erstes (TE1) und zweites Trennelement (TE2) unterschiedliche Trennelemente verwendet werden.

**6.** Verfahren nach einem der Ansprüche 4 bis 6,
wobei als Trennelement (TE1, TE2) ein galvanisch trennendes optisches, magnetisches und/oder kapazitives Trennelement verwendet wird.

**7.** Verfahren nach einem der vorangegangenen Ansprüche,
wobei als Ansteuereinheit (T1, T2) eine Ansteuereinheit (T1, T2) verwendet wird, die nur bei Vorliegen eines bestimmten Signals das Schalten des Halbleiterschalters (S1, S2) von der Steuereinheit (P1, P2) zulässt.

**8.** Verfahren nach Anspruch 7,
wobei als bestimmtes Signal eine Frequenz, eine Spannung, eine Spannungsänderung, ein Strom und/oder eine Stromänderung verwendet werden.

**9.** Verfahren nach den Ansprüchen 7 oder 8,
wobei als Signal ein Signal in einem Intervall verwendet wird.

**10.** Verfahren nach einem der vorangegangenen Ansprüche,
wobei jedem Halbleiterschalter (S1, S2) eine eigene Steuereinheit (P1, P2) zugeordnet wird.

**11.** Verfahren nach einem der vorangegangenen Ansprüche,
wobei als Halbleiterschalter (S1, S2) ein MOSFET, ein IGBT, ein Thyristor und/oder ein Bipolartransistor verwendet werden.

**12.** Verfahren nach einem der vorangegangen Ansprüche,
wobei das Schliessen des Schalters (S) zu Testzwecken in regelmässigen Abständen oder aufgrund mindestens einer vorher definierten Regel durchgeführt wird.

**13.** Schalter (S) einer elektrischen Anlage,
- mit einem Eingang (E) und einem Ausgang (A),
- mit mindestens zwei in Serie geschaltete Halbleiterschalter (S1, S2), die zwischen dem Eingang (E) und dem Ausgang (A) angeordnet sind,
- mit mindestens einer mit den mindestens zwei Halbleiterschaltern (S1, S2) verbundene Steuereinheit (P, P1, P2) zum jeweils abwechselnden Schliessen einer der mindestens zwei Halbleiterschalter (S1, S2), zum Überprüfen, ob ein Signal am Ausgang (A) anliegt und zum Schliessen der mindestens zwei Halbleiterschalter (S1, S2) bei Ausbleiben des jeweiligen Signals.
